# EUROPEAN PATENT APPLICATION

(11) **EP 2 096 091 A2**
(43) Date of publication of application: **02.09.2009**
(21) Application number: 09250510.6
(22) Date of filing: 25.02.2009
(51) Int. Cl.: C04B 35/45, H01L 39/24

(54) **Oxide superconductive target for laser vapor deposition and method of manufacturing the same**

(30) Priority: 27.02.2008 JP 2008046049
(71) Applicant: Fujikura, Ltd., Tokyo (JP)
(72) Inventor: Kakimoto, Kazuomi, Tokyo (JP)
(74) Representative: Carter, Stephen John

(57) **Abstract**

A method of manufacturing an oxide superconductive target for a laser vapor deposition, which is used when an oxide film is formed in a laser vapor deposition system including the steps of: mixing rare-earth oxide powder, barium carbonate powder, and copper oxide powder at a predetermined composition ratio to obtain a mixed powder; press-molding the mixed powder to form a compressed-molded compact; and performing a partial melt molding the compressed-molded compact.
An oxide superconductive target for a laser vapour deposition, which is used when an oxide film is formed in a laser vapour deposition system, comprising a target main body, the elemental ratio of the target main body being substantially Y:Ba:Cu=1:2:3; and a silver net is disposed in a position in the range of 10% to 40% of the target thickness form the bottom of the target main body.

## Description

### BACKGROUND OF THE INVENTION

### Field of the Invention

The present invention relates to an oxide target and a method of manufacturing the same, which is useful for a laser vapor deposition system for forming an oxide film on the surface of a substrate by irradiating a target with a laser beam to generate fine particles of oxide from the target surface thereby depositing the fine particles on the surface of the substrate. The present invention particularly relates to an oxide superconductive target and a method of manufacturing the same, which is prevented from developing cracks caused by a high laser output and a high-temperature atmosphere.

### Description of the Related Art

A method in which an oxide is press-molded and then sintered at high temperature has been used in the case of producing a target formed of an oxide superconductor, which is typified by an oxide target for laser vapor deposition, particularly, a Y-Ba-Cu-O-based oxide superconductor. As an example thereof, Patent Document 1 (Japanese Unexamined Patent Application, First Publication No. H04-280856) discloses a preparation method of an oxide superconductive sintered body, which includes: producing synthetic powder containing an RE-based 123 phase and an RE-based 211 phase of fine crystal grains by subjecting mixed powder obtained when raw material powders are mixed at a predetermined ratio to calcining at 900°C or higher; producing the RE-based 123 phase by burning a compact formed from the synthetic powder, at 920°C to 1000°C; producing the RE-based 211 phase as amain phase by subsequently burning the formed body at 1050°C to 1200°C; and growing the RE-based 123 phase by burning at 920°C to 1000°C.

In addition, Patent Document 2 (Japanese Unexamined Patent Application, First Publication No. H06-305891) discloses a target for preparing a thin film of an oxide superconductor, obtained by partially melt-molding a compact of amorphous powder followed by gradual cooling, which has an apparent density of 95% or more and a composition of Y_{1±α} Ba_{2±β} Cu_{3±γ} O₇₋₈ (α ≤ 0.8, β≤0.4, γ≤0.4, and -2≤δ≤1).

However, in the preparation method of an oxide superconductive sintered body disclosed in Patent Document 1, the formation temperature is too high and a reinforcing material or the like could not be applied to the inside of the target because the oxide superconductive powder is sintered after its synthesis. Moreover, complicated production processes such as powder synthesis, pulverization, press-molding, sintering and the like caused a problem such as an increase in the cost.

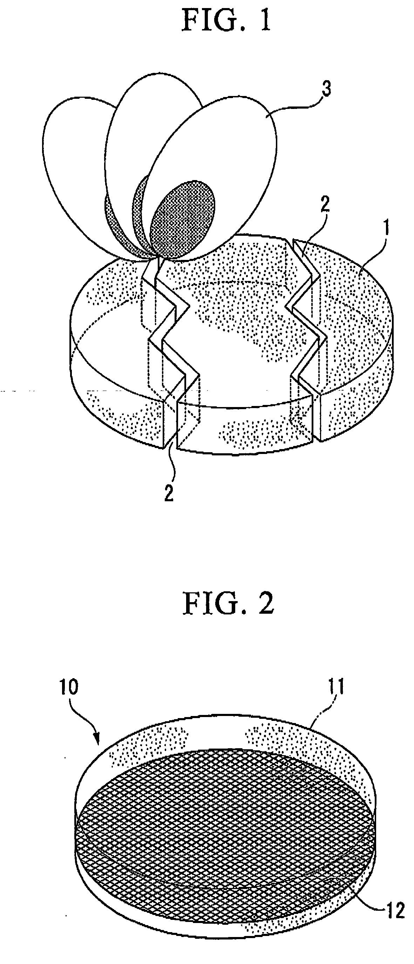

Furthermore, the biggest problem in the related technology disclosed in Patent Document 1 and Patent Document 2 is that the target is easily cracked when used with a high laser output and in a high-temperature atmosphere, because the target is composed of a sintered body of an oxide and has no reinforcing structure. FIG 1 is a view showing the disarray of a plume 3 generated when a laser beam is irradiated on a target 1 having cracks 2. As shown in FIG. 1, if the cracks 2 are generated in the target 1, even a small gap created by the cracks 2 may cause a portion irradiated with a laser beam to be uneven. Consequently, the plume 3 tilts and becomes unstable, thereby a stable film formation cannot be achieved.

In consideration of the above-mentioned problems, a preferred object of the invention is to provide an oxide target for laser deposition and a method of manufacturing the same, which is useful for a laser vapor deposition system, wherein development of cracks in the target due to a high laser output and high-temperature atmosphere can be prevented, thereby allowing a stable film formation for a long period of time.

### SUMMARY OF THE INVENTION

The present invention provides the following aspects:
(1) A first aspect of the present invention is a method of manufacturing an oxide superconductive target for a laser vapor deposition, which is used when an oxide film is formed in a laser vapor deposition system including the steps of: mixing rare-earth oxide powder, barium carbonate powder, and copper oxide powder at a predetermined composition ratio to obtain a mixed powder; press-molding the mixed powder to form a compressed-molded compact; and performing a partial melt molding of the compressed-molded compact.
(2) In the method of manufacturing an oxide superconductive target for laser vapor deposition as described in (1), it is preferable to further include a step of putting the mixed powder and a silver net into a mold of a press-molding apparatus so as to cover the silver net with the mixed powder prior to the press-molding step.
(3) A second aspect of the present invention is an oxide superconductive target for a laser vapor deposition, which is used when an oxide film is formed in a laser vapor deposition system, including: a target main body, a silver net embedded in the target main body, wherein the silver net is disposed in a position in the range of 10% to 40% of the target thickness from the bottom of the target main body; and an elemental ratio of the target main body is substantially Y:Ba:Cu=1:2:3.
(4) In the oxide superconductive target for a laser vapor deposition as described in (3), it is preferable that an area of each hole in the silver net is in the range of 1 to 10 mm² and a diameter of each silver thread of the silver net is in the range of 1 to 2 mm, providing that the silver net includes a plurality of silver threads disposed at an equal distance so as to form a plurality of holes therebetween.

According to the first aspect of the invention as described in (1), the oxide superconductive target for laser vapor deposition can be obtained by mixing rare-earth oxide powder, barium carbonate powder, and copper oxide powder at a predetermined ratio, and press-molding the mixed powder and further performing a partial melt molding. Accordingly, the target forming temperature can be lowered because there is no need to form a compact of, for example, the RE-based 123 phase and amorphous powder unlike in the conventional technique. Moreover, the target forming process can be simplified and the production time can be reduced, thereby achieving a low production cost.

Furthermore, according to the first aspect of the invention as described in (2) above and the oxide superconductive target for laser vapor deposition according to the second aspect of the invention as described in (3) above, a constitution in which a silver net is embedded in a main body of the target obtained by press-molding powders and further performing a partial melt-molding is employed. As a result, the silver net can prevent the development of cracks in the target, the target use time can be prolonged, and a stable film formation for a long period of time can be realized.

### BRIEF DESCRIPTION OF THE DRAWINGS

FIG. 1 is a view showing the disarray of plumes generated when a laser beam is irradiated on a target having cracks.
FIG. 2 is a perspective view transparently showing a main section of an embodiment of an oxide superconductive target for laser vapor deposition according to the present invention.

### DETAILED DESCRIPTION OF THE INVENTION

Hereinafter, an exemplary embodiment of the present invention will be explained with reference to the accompanying drawings.

FIG. 2 is a perspective view transparently showing a main section of an embodiment of an oxide superconductive target for laser vapor deposition of the present invention, and in the figure, reference numeral 10 denotes an oxide superconductive target for laser vapor deposition, reference numeral 11 denotes a target main body, and reference numeral 12 denotes a silver net.

The oxide superconductive target 10 (hereinafter abbreviated as a target 10) for laser vapor deposition of this embodiment is an oxide target useful for a laser vapor deposition system (not illustrated) for forming an oxide film (not illustrated) on the surface of a substrate by irradiating the target 10 with a laser beam to generate fine particles of oxide from a surface of the target 10, thereby depositing the fine particles on the surface of the substrate (not illustrated) to form the oxide film. In the oxide target 10, the silver net 12 is embedded in the target main body 11 by mixing rare-earth oxide powder, barium carbonate powder and copper oxide powder at a predetermined ratio, and press-molding the mixed powder and further performing a partial melt molding.

The target main body 11 is obtained by partially melt-molding rare-earth oxide powder, barium carbonate powder, and copper oxide powder as materials for an oxide superconductor, which is the object of the invention. In the present invention, an oxide superconductor of the production object can be exemplified by a Y-Ba-Cu-O-based oxide superconductor or the like. A typical elemental ratio of the Y-Ba-Cu-O-based oxide superconductor is Y:Ba:Cu=1:2:3, but not limited thereto. Hereinafter, a case where the oxide superconductor is a Y-Ba-Cu-O-based oxide superconductor will be explained.

In this case, for the target main body 11, each material of yttrium oxide powder, barium carbonate powder, and copper oxide powder is measured so that an elemental ratio of the target main body 11 at a time of completing the target 10 is substantially Y:Ba:Cu=1:2:3, and the measured powders are mixed. With regard to the amount of each material, it is desirable that a change in the composition ratio due to the powder loss upon a partial-melt molding be considered, and by compensating the loss amount, the initial amount of each material is determined to give the elemental ratio at the time of completing the target of Y:Ba:Cu=1:2:3.

The silver net 12 includes a plurality of silver threads having equal diameters and is disposed at an equal distance so as to define a plurality of holes therebetween. The formed plurality of holes have equal areas. The silver net 12 is not particularly limited with respect to each hole or a diameter of a silver thread, but it is preferable to use a silver net of which an area of each hole in the silver net is in the range of 1 to 10 mm² based on the result of the example to be described below, and the thread diameter is in the range of 1 to 2 mm.

It is preferable to dispose the silver net 12 on the bottom side from the center of the thickness direction of the target main body 11 so as to prevent unstable film formation in the silver net 12 due to its exposure resulting from the surface of the target main body 11 being scraped in accordance with the development of the film formation. As a result of the example described below, it is preferable to dispose the silver net 12 in a position in the range of 10% to 40%, more preferably within the range of 20% to 30% of the target thickness from the bottom of the target main body 11.

Here, a production method of the target 10 of the example will be explained. Each of materials including yttrium oxide powder, barium carbonate powder, and copper oxide powder of about 1µm in average diameter and the silver net 12 are prepared. As described above, each of the materials including yttrium oxide power, barium carbonate powder and copper oxide powder are measured so that the elemental ratio of the target main body 11 at a time of the target completion is Y:Ba:Cu=1:2:3, put in a stirrer such as a ball mill (not illustrated), and stirred to be mixed sufficiently in order to obtain a mixed powder.

Next, a part of the mixed powder (which will form a bottom side of the target 10) is put into a mold of a press-molding apparatus (not illustrated), the silver net 12 is applied thereto, and the remaining mixed powder (which will form a top side of the target 10) is added thereon. The silver net 12 is set to be covered with the mixed powder and press-molding is performed to obtain a compressed-molded compact. A condition of the press-molding is not particularly limited, but it is preferable to perform the process under the condition of a pressure of about 10 to 20 MPa for about 1 minute at room temperature.

Next, the molded body of the press-molding is pulled out of the mold and put in an electric furnace (not illustrated) for heat treatment for 50 to 100 hours in a temperature range of 800°C to 950°C, or preferably at approximately 880°C, in the atmosphere. Accordingly, as shown in FIG. 2, an oxide superconductive target for laser vapor deposition having a structure in which the silver net 12 is buried in the target main body 11 comprising a molded body of partial melt-molded Y-Ba-Cu-O-based oxide superconductive material can be obtained.

The target 10 of the present embodiment is obtained by mixing rare-earth oxide powder, barium carbonate powder, and copper oxide power at a predetermined ratio, and press-molding the mixed power and further performing partial melt-molding. Accordingly, the target forming temperature may be low, because there is no need to form a compact of an RE-based 123 phase or amorphous powder as in the conventional technique. In addition, the target molding process can be simplified and the production time can be reduced, thereby achieving a low cost.

Further, the target 10 of the present embodiment has a constitution in which the silver net 12 is embedded in a main body 11 of the target 10 obtained by press-molding powders and further performing a partial melt-molding. Consequently, since the development of cracks in the target 10 can be prevented by the silver net 12, the target use time can be prolonged, and a stable film formation for a long period of time can be achieved.

### Examples

Each of the materials including yttrium oxide power, barium carbonate power, and copper oxide powder of about 1 µm of average diameter was measured so as to adjust the elemental ratio of the target main body 11 at a time of the completion of the target 10 to substantially Y:Ba:Cu=1:2:3, injected to a ball mill, and stirred sufficiently to be mixed to obtain a mixed powder. Also, a silver net 12 having the area of each hole and diameter of the silver thread was prepared as in Table 1.

The mixed powder and the silver net 12 were put into the mold of a press-molding apparatus, and the obtained molded body of the press-molding was put in an electric furnace for heat treatment at 880°C for 50 to 100 hours in the atmosphere. As a result, target 10 according to an example of the present invention (Sample No. 1 to 11 in Table 1) was produced. The installation position of the silver net 12 was changed to a range of 0 to 5 mm of a height from the bottom of the target 10, as shown in Table 1.

The targets with sample numbers 1 to 11 of the example were tested after producing samples with a diameter of 100 mm and thickness of 10 mm. The target having this size is expected to show an improvement in terms of cost, if the target can be used for about 100 hours in laser vapor deposition.

The targets with sample numbers. 1 to 11 of the example were set in a laser vapor deposition system, irradiated with a pulsed laser beam on the surface, and the limit time of the target use was measured. The result thereof is shown in Table 1.

Furthermore, as a comparative example, a Y-based oxide superconductive sintered body was prepared based on the production method described in Patent Document 1 to use as a target of the comparative example (Sample No. 12 in Table 1). Then, the limit time of the target use in laser vapor deposition was measured and compared as in the example. The result is shown in Table 1.

**Table 1**

| Sample No. | Area of each hole (mm²) | Diameter of Silver Thread | Height from Bottom (mm) | Limit Time of Use (h) |
|---|---|---|---|---|
| 1 | 1 | 1 | 3 | 100 |
| 2 | 5 | 1 | 3 | 100 |
| 3 | 10 | 1 | 3 | 100 |
| 4 | 20 | 1 | 3 | 70 |
| 5 | No silver net | 0 | 0 | 50 |
| 6 | 10 | 0.5 | 3 | 80 |
| 7 | 10 | 2 | 3 | 100 |
| 8 | 10 | 4 | 3 | 70 |
| 9 | 10 | 1 | 2 | 100 |
| 10 | 10 | 1 | 1 | 60 |
| 11 | 10 | 1 | 5 | 70 |
| 12 | | Comparative example | | 20 |

According to the result of Table 1, a crack occurred in the comparative example, and a stable film formation was limited to about 20 hours.

On the other hand, the sample numbers 1 to. 11 according to an example of the present invention did not easily generate a crack even in a target without a silver net and showed an improvement in the limit time of target use as compared to the comparative example.

When a target had a silver net and satisfied conditions of the area of each hole of 1 to 10 mm², diameter of a silver thread of 1 to 2 mm, and location in 2 to 3 mm from the bottom, a lifetime of 100 hours could be achieved.

With regard to the area of each hole in the silver net and diameter of a silver thread in the silver net, if the space that oxides occupied in the silver net side was too large, the strength of the silver net became weak, and the limit time of use became short due to damage in the silver net or the like.

Moreover, with respect to the installation position of the silver net (a height from the bottom), the effect to suppress development of cracks in a target in the thickness direction reduced as the silver net approached the target surface. On the contrary, the effect to suppress development of cracks in a target in the thickness direction improved as the silver net approached the target center portion. However, a decrease in the use limit time resulted because the thickness of the target that could be used became thin.

While preferred embodiments of the invention will be described and illustrated below, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A method of manufacturing an oxide superconductive target for a laser vapor deposition, which is used when an oxide film is formed in a laser vapor deposition system, the method comprising the steps of:
mixing rare-earth oxide powder, barium carbonate powder, and copper oxide powder at a predetermined composition ratio to obtain a mixed powder;
press-molding the mixed powder to form a compressed-molded compact; and
performing a partial melt molding the compressed-molded compact.

2. The method of manufacturing an oxide superconductive target for a laser vapor deposition according to claim 1, further comprising the step of
putting the mixed powder and a silver net into a mold of a press-molding apparatus so as to cover the silver net with the mixed powder prior to the press-molding step.

3. An oxide superconductive target for a laser vapor deposition, which is used when an oxide film is formed in a laser vapor deposition system, comprising:
a target main body, the elemental ratio of the target main body being substantially Y:Ba:Cu=1:2:3; and
a silver net embedded in the target main body, wherein
the silver net is disposed in a position in the range of 10% to 40% of the target thickness from the bottom of the target main body.

4. The oxide superconductive target for a laser vapor deposition according to claim 3, wherein
the silver net includes a plurality of silver threads disposed at an equal distance so as to form a plurality of holes therebetween wherein,
the area of the each hole is in the range of 1 to 10 mm², and
the diameter of the silver thread is in the range of 1 to 2 mm.
